# EUROPEAN PATENT SPECIFICATION

(11) **EP 2 903 149 B1**
(45) Date of publication and mention of the grant of the patent: **18.09.2019**
(21) Application number: 12885312.4
(22) Date of filing: 28.09.2012
(51) Int. Cl.: H02M 7/537, H02M 1/00, H01L 25/18, H01L 29/861, H03K 17/16, H01F 17/00, H01L 49/02, H02M 7/00, H02M 7/538

(54) **SEMICONDUCTOR DEVICE AND POWER CONVERSION APPARATUS USING SAME**
HALBLEITERBAUELEMENT UND SPANNUNGSUMWANDLUNGSVORRICHTUNG DAMIT
DISPOSITIF SEMI-CONDUCTEUR ET APPAREIL DE CONVERSION D'ÉNERGIE L'UTILISANT

(43) Date of publication of application: 05.08.2015
(73) Proprietor: Hitachi, Ltd., Tokyo 100-8280 (JP)
(72) Inventor: OHNISHI, Masami, Tokyo 100-8280 (JP)
(74) Representative: Mewburn Ellis LLP
(86) International application number: PCT/JP2012/075005
(87) International publication number: WO 2014/049807

(56) References cited:
- JP-A- H 118 968
- JP-A- H0 888 313
- JP-A- H05 135 950
- JP-A- 2001 245 479
- JP-A- 2004 095 670
- JP-A- 2009 032 769
- JP-A- 2009 195 054
- JP-A- 2009 225 570
- JP-A- 2012 019 568
- JP-A- 2012 050 065
- US-A1- 2012 032 725

## Description

### Technical Field

The present invention relates to a semiconductor device, and especially relates to a semiconductor device using multiple circuits in which transistors and diodes are connected in parallel.

### Background Art

Recently, in the field of a power conversion apparatus (inverter unit) used for generating an alternating current from a direct current power source necessary for a motor circuit and a drive circuit of wind power generation/solar power generation facilities, a motor and the like, an inverter unit capable of flowing a high current is required in association with a growing scale in power generation and a high output power unit. However, on the other hand, power conversion efficiency can be increased by installing the inverter unit near a power generator and a power driving unit, and therefore a small and light inverter unit is also needed. During operating at a high current, the inverter unit is increasingly heated by loss of a power semiconductor device such as a switching device such as an IGBT, a Si-MOSFET, a SiC-MOSFET, and a GaN-FET and a recovery device such as a Si diode, a SiC diode, and a GaN diode, and a radiator accounts for a large part of the capacity of the inverter unit for suppressing the heating, and therefore, downsizing and weight reduction become difficult. As a result, reduction in loss of the power semiconductor device used in the inverter unit becomes a major issue.

To provide a small, light, and low-loss inverter, a maximum loss reduction effect can be obtained by reducing loss of a switching device used for a power semiconductor device. However, reduction in loss of a recovery device accounts for weight following the reduction in loss of the switching device. Therefore, it is important to improve the loss.

For reducing the loss, Patent Literature 1 discloses that a speed for blocking a recovery current by diodes is slowed down by using two types of diodes, i.e., a Si diode and a diode having an ON voltage different from that of a SiC diode, to reduce a noise by a ringing current flowing in a recovery device. Therefore, occurrence of the ringing current at both ends of the diodes can be prevented.

### Citation List

### Patent Literature

Patent Literature 1: JP 2009-032769 A

US2012/0032725 discloses a power module comprises: first and second terminals; first and second switching elements having a first electrode and a second electrode which is connected to the second terminal; first and second wirings respectively connecting the first electrodes of the first and second switching elements to the first terminal; and a third wiring directly connecting the first electrode of the first switching element to the first electrode of the second switching element, wherein parasitic inductances of the first and second wiring are different or switching characteristics of the first and second switching elements are different.

### Summary of Invention

### Technical Problem

An example for reducing loss of a recovery device includes use of a SiC diode and a GaN diode. Turn-on loss and recovery loss are reduced by using the diodes since a reverse recovery current does not flow. Furthermore, a switching speed (turn-on speed) can be speeded up by lowering a gate resistance value of a switching device such as an IGBT, a Si-MOSFET, a SiC-MOSFET, and a GaN-FET. Therefore, the loss can be further reduced. Also, each of element circuits can be speeded up and downsized. However, a junction capacitance is more or less included in a schottky structure like a SiC diode. Therefore, a power supply voltage is applied at both ends of a diode which is a recovery device when the switching device is turned on, and a resonance current (ringing current) flows by resonance between the junction capacitance of the diode and an inductance of a main circuit.

Regardless of whether a SiC diode is used, the junction capacitance cannot be zero in any of diodes such as a Si diode and a GaN diode. Therefore, there is a disadvantage that by applying a high surge voltage (ringing voltage) to both terminals of a diode by resonance with a power supply voltage, a ringing voltage is increased.

Also, in a configuration described in Patent Literature 1, a Si diode and a SiC diode are required to be separately mounted, and therefore a manufacturing process is complicated.

An object of the present invention is to solve such problems, and to provide a low-loss semiconductor device.

### Solution to Problem

To achieve the above object, for example, configurations described in claims are applied. The present application includes multiple means to solve the above issue. Present invention provides a semiconductor device as set forth is in claim 1.

### Advantageous Effects of Invention

According to the present invention, a semiconductor device, which can be simply manufactured and has low loss, can be provided.

### Brief Description of Drawings

FIG. 1 is a circuit diagram illustrating a configuration of an inverter unit according to a first embodiment of the present invention.
FIG. 2 is a circuit diagram illustrating a configuration of an inverter unit according to a second embodiment of the present invention.
FIG. 3 is a circuit diagram illustrating a configuration of an inverter unit according to a third embodiment of the present invention.
FIG. 4 is a circuit diagram illustrating a configuration of an inverter unit according to a fourth embodiment of the present invention.
FIG. 5 is a diagram illustrating an equivalent circuit of an inductance and a diode and a damped sine wave oscillation and a frequency of a damped sine wave oscillation.
FIG. 6 is conceptual diagrams for comparing ringing current waveforms between a conventional technique and the embodiment.
FIG. 7 is a view illustrating an example for changing an inductance.
FIG. 8 is a view illustrating an example for changing an inductance.
FIG. 9 is a view illustrating an example for changing an inductance.
FIG. 10 is a view illustrating an example for changing an inductance.
FIG. 11 is a view illustrating an example for changing an inductance.
FIG. 12 is a view illustrating a state connecting FIG. 10 in parallel as an example for changing an inductance.
FIG. 13 is a view illustrating an actual mounting structure in which a recovery diode with one chip and a switching device are actually mounted.
FIG. 14 is a view illustrating an actual mounting structure in which a recovery diode connecting in four parallels and a switching device are actually mounted by using FIG. 11.
FIG. 15 is views illustrating a double side cooling type power module using the semiconductor device according to the present invention.

### Description of Embodiments

Hereinafter, with reference to drawings, a basic configuration of an inverter unit according to modes for carrying out the present invention (hereinafter called the embodiments) will be described by using circuit diagrams, and a feature configuration of the present embodiments will be described next. Also, components common and similar in the figures are denoted by the same signs, and redundant descriptions thereof will be omitted.

### First Example

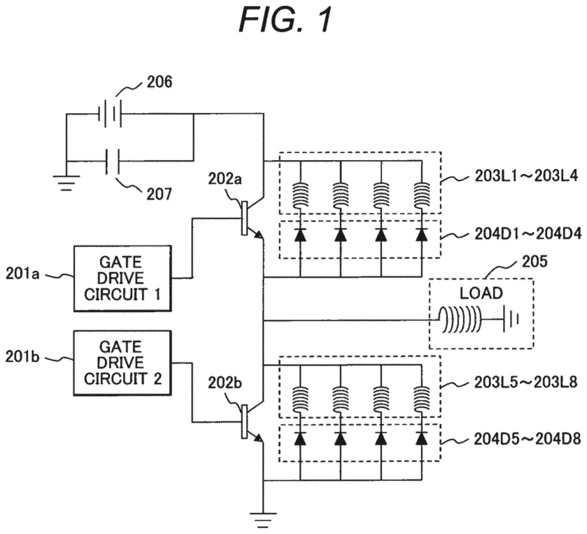

FIG. 1 is a circuit diagram illustrating a basic configuration of an inverter unit according to a first embodiment of the present invention. The inverter unit includes a switching device on a high-voltage side 202a, a switching upper arm circuit, a switching device on a low-voltage side 202b, a switching lower arm circuit, a direct current power source 206, a capacitor 207, a gate drive circuits 201a and 201b, and a load 205. The switching upper arm circuit includes recovery diodes 204D1 to 204D4 connected in parallel to a source-drain path of the switching device on a high-voltage side 202a, and inductances 203L1 to 203L4 connected in series on a cathode side of each recovery diode. The switching lower arm circuit includes recovery diodes 204D5 to 204D8 connected in parallel to a source-drain path of the switching device on a low-voltage side 202b, and inductances 203L5 to 203L8 connected in series on the cathode side of each recovery diodes. The direct current power source 206 is a main power source. The capacitor 207 suppresses fluctuation of a power supply voltage. The gate drive circuits 201a and 201b turn on and off the switching device on a high-voltage side 202a and the switching device on a low-voltage side 202b. The load 205 is connected to a connection point between the switching device on a high-voltage side 202a and the switching device on a low-voltage side 202b. The direct current power source 206, the switching device on a high-voltage side 202a, and the switching device on a low-voltage side 202b are connected in series in this order to a reference potential. In the present example, four sets of inductances and recovery diodes are connected in parallel in each of the switching upper and lower arm circuits. However, in the upper and lower arm circuits, a set number of the inductances and the recovery diodes may be asymmetric.

By switching ON/OFF of the switching devices 202a and 202b, currents in different directions alternately flow to the load 205, and an alternating current magnetic field is generated. In such case, if both of the switching devices are instantaneously turned on, a high current flows in an entire circuit, and the entire circuit shorts out. Therefore, a time for turning off both of the switching devices (dead time) is set. To release an induced current generated at the load 205 during the dead time, a set of a series inductance and a recovery diode is provided above and below the upper arm circuit and the lower arm circuit. A forward direction of the recovery diodes 204D1 to 204D8 is set to a direction in which a current flows from the reference potential to the direct current power source 206, so that the recovery diodes can pass the induced current.

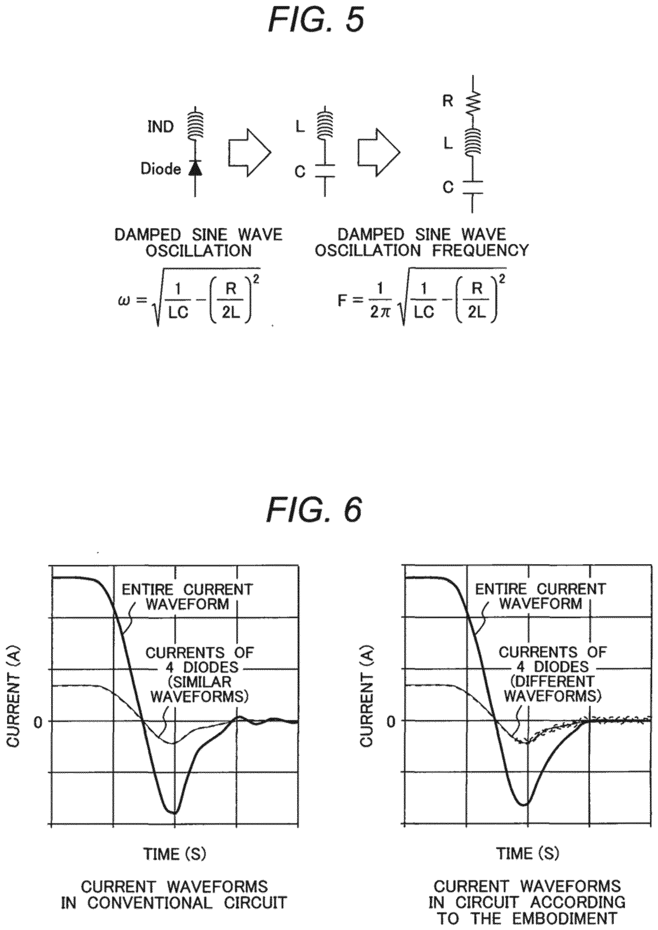

A frequency of a ringing current flowing to each diode changes by changing values of the series inductances 203L1 to 203L4 in the switching upper arm or the series inductances 203L5 to 203L8 in the switching lower arm based on a formula of a damped sine wave oscillation and a formula of the damped sine wave oscillation frequency, which are indicated in FIG. 5. Therefore, a ringing current frequency in the entire upper arm circuit can be lowered like a current waveform illustrated in a right diagram of FIG. 6 by weakening ringing currents of diodes connected in parallel each other. If the above measure is taken to both of the series inductances in the upper and lower arms, a greater effect can be obtained.

The series inductances are determined by a distance (path) in which a current flows from a direct current power source to a diode, and therefore the series inductance 203 can be changed by changing the distance. Furthermore, when ringing currents flowing to the diodes 204D1 to 204D4 are denoted by I₁ to I₄, and frequencies of the currents I₁ to I₄ flowing in each of 204D1 to 204D4 are the same, a peak value of ringing currents may be quadrupled by superposition of both of them. Therefore, with respect to a relationship among frequency f₁ of I₁, frequency f₂ of I₂, frequency f₃ of I₃, and frequency f₄ of I₄, the peak value of ringing currents can be lowered by varying each frequency like f₁ ≠ f₂ ≠ f₃ ≠ f₄. For example, if a proportion of each of the frequencies is an odd multiple and not equal, the peak value can be lowered by approximately 2.92 times.

Other than the frequency, a ringing current in the arm can be cancelled by changing a phase of the ringing current. However, an inductance value, which has no effect on a signal current, can apply an inductance in the order of several nano. The frequency of the ringing current needs to be in the order of several GHz to change the phase of the ringing current by such inductance, and therefore change in the phase is difficult and impractical.

Although Si is used for all materials of recovery diodes in the present example, all of them may be SiC diodes or GaN diodes. In view of aspects of prevention of device degradation due to current concentration and a temperature characteristic, devices of the recovery diodes 203L1 to 203L8 in the upper and lower arms are preferably the same type (Si, SiC or GaN).

In light of the above, the semiconductor device according to the present example includes a direct current power source, a reference potential, first and second arm circuits, and a load inductor. The first and second arm circuits are connected in series between the reference potential and the direct current power source. The load inductor is connected to a connection point between the first arm circuit and the second arm circuit. The first arm circuit includes a first switching device, and multiple first diodes connected in parallel to a current path of the first switching device. The second arm circuit includes a second switching device, and multiple second diodes connected in parallel to a current path of the second switching device. A forward direction of the first and second diodes is a direction from the reference potential to the direct current power source. All of the first and second diodes are Si diodes, SiC diodes, or GaN diodes. Each of distances between the multiple first diodes and an output terminal of the direct current power source is different.

By cancelling ringing currents each other, which generate in recovery diodes in arms by the above characteristics, noise in the entire arm can be reduced, and a low-loss semiconductor device can be provided. Also, since the same diodes are used, a manufacturing process is simple, and it is hard to generate device degradation by current concentration.

### Second Example

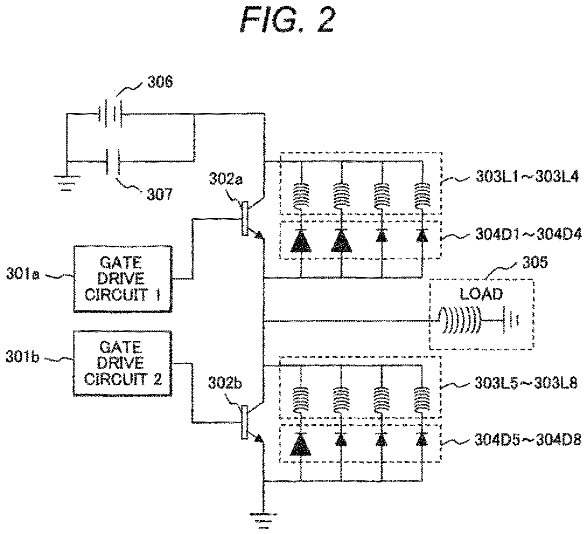

FIG. 2 is a circuit diagram illustrating a basic configuration of an inverter unit according to a second embodiment of the present invention. A point different from the circuit configuration described in the first example is that a frequency of a ringing current can be further positively changed by changing a chip size, i. e., a junction capacitance, in each of recovery diodes 304D1 to 304D4 in a switching upper arm and recovery diodes 304D5 to 304D8 in a switching lower arm, which are further used, in addition to changing values of series inductances 303L1 to 303L4 in a switching upper arm and series inductances 303L5 to 303L8 in a switching lower arm. Therefore, in comparison with the first example, a semiconductor device with lower loss can be provided.

### Third Example

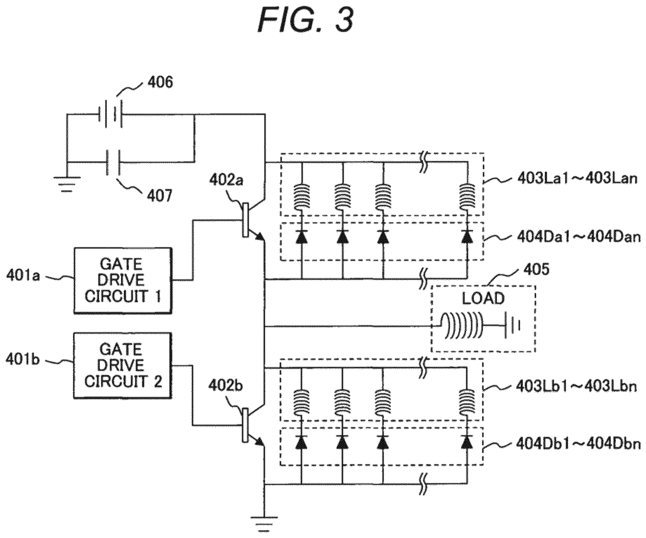

FIG. 3 is a circuit diagram illustrating a basic configuration of an inverter unit according to a third embodiment of the present invention. A point different from the circuit configuration described in the first example is that the inverter unit includes recovery diodes 404Da1 to 404Dan and series inductances 403La1 to 403Lan in a switching upper arm, and recovery diodes 404Db1 to 404Dbn and series inductances 403Lb1 to 403Lbn (n is a natural number more than 1) in a switching lower arm, and a parallel number is increased to n parallels. By increasing a number of split chips, a chip size can be basically downsized and a yield is improved. Also, by increasing split chips, variable frequencies, i.e., different frequency components, are increased, and an absolute value of a value of a current flowing to the split chips is lowered. Therefore, an effect by cancelling ringing currents each other is further improved in comparison with the first example, and in comparison with the first example, a semiconductor device with lower loss can be provided.

### Fourth Example

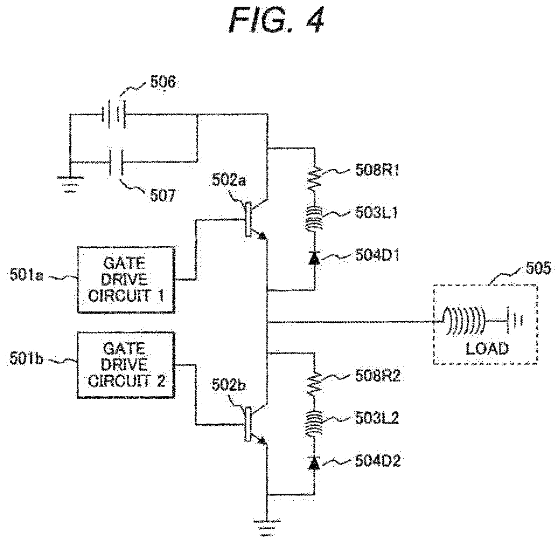

FIG. 4 is a circuit diagram illustrating a basic configuration of a semiconductor device according to a fourth example of the present invention. A point different from the circuit configuration described in the first example is that resistances 508R1 to 2 are connected in series to recovery diodes 504D1 to 2 and inductances 503L1 to 2.

A ringing current generated in a recovery diode is further damped by connecting resistance components to an inductance of an L component and a diode of a C component in series. By the configuration, the ringing current is lowered, and a low-loss semiconductor device can be provided. Also, a similar effect can be obtained by resistance components by a skin effect in addition to applying a resistance device.

Upper and lower arms according to the present example have asymmetric shapes as an example illustrating that the effect of the present invention can be obtained by applying the present invention to one of the arms even if the upper and lower arms are asymmetric.

### Fifth Example

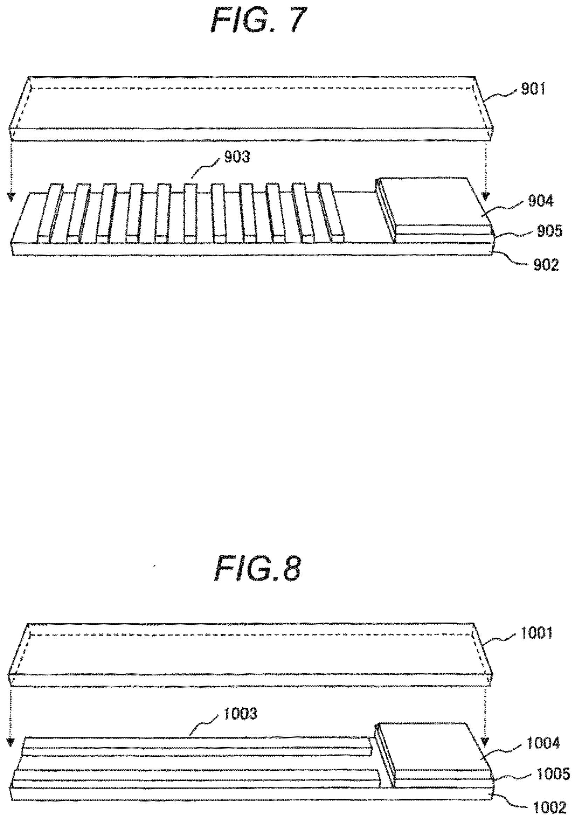

FIG. 7 is a structural view illustrating an inductance of an inverter unit according to a fifth embodiment of the present invention for realizing control of inductances according to the above-described first to third examples. A recovery diode 904 is sandwiched between an upper metal electrode 901 and a lower metal electrode 902, and a chip height of the recovery diode 904 is herein adjusted by laying a metal spacer 905. Also, an asperity structure 903 is provided to the lower metal electrode 902 so as to be perpendicular to a current traveling direction. The asperity structure may be provided to both of the upper metal electrode 901 and the lower metal electrode 902 or either of the upper metal electrode 901 or the lower metal electrode 902. The inductance can be controlled by a presence, a number, or a groove depth and a pitch of the asperity structure 903. Therefore, a ringing frequency can be further positively changed, and ringing amplitude can be reduced.

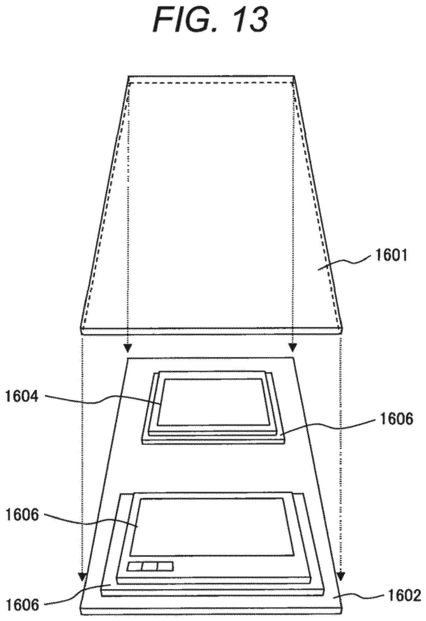

In general, a switching device and a recovery diode are supposedly mounted on the same electrode as illustrated in FIG. 13. Therefore, if inductances are changed as described in the first to third examples, a signal current which is input to a gate of a switching device through the same metal electrode is also affected. In the present example, a skin effect is applied by focusing on the fact that a frequency of a ringing current is several ten to several hundred MHz, which is higher than a fundamental frequency three digits or more, which is several ten to several hundred kHz, of a current applied to the gate of the switching device.

A ringing current frequency is in the order of MHz, and the ringing current flows on a metal surface by utilizing a skin effect. However, a signal of a gate drive current is in the order of kHz, and the gate drive current flows in an entire metal. As a result of the effect, while an inductance is seemed to increase with respect to a ringing current having a high frequency, a circuit can be operated without applying an inductance to the gate drive current which is a signal current. Specifically, the present example is characterized in that a distance on an electrode surface can be increased by providing an asperity structure, and a series inductance is seemed to increase with respect to a ringing current flowing on the electrode surface. Also, a ringing current having a further high frequency by a proximity effect, in which a current moving in a different direction is approximated, is concentrated on a surface. As a result of these effects, an inductance is increased on a surface of the asperity structure 903 in a high frequency area generating ringing. Therefore, a low-loss semiconductor device can be provided.

In the present example, although a spacer is provided on an electrode and a protrusion is provided on an electrode surface, the effect similar to the above can be obtained by digging a groove on an electrode to provide a depression on the electrode surface, and therefore this is included in the asperity structure described in the present description. Also, a structure providing both of a protrusion and a depression on the electrode surface is obviously included in the asperity structure according to the present invention. In the asperity structure, the height of a spacer is set to 0.5 millimeter in the present example. However, a distance from the electrode surface is preferably approximately plus or minus 0.1 to 1 millimeter. This is because an inductance is applied to a signal current in addition to a ringing current if an asperity on the electrode surface is higher than 1 millimeter. Also, if the asperity is smaller than 0.1 millimeter, a skin effect cannot be obtained. Therefore, the asperity needs a certain level of height.

### Sixth Example

FIG. 8 is a structural view illustrating an inductance of an inverter unit according to another fifth embodiment for realizing control of the inductance in the above-described fifth example. A point different from the structure indicated in the fifth example is that an asperity is provided parallel to a current direction, and an inductance can be controlled especially by providing protrusions to both edges like a parallel asperity structure 1003 illustrated in FIG. 8, or providing a protrusion to a center only, or providing protrusions to both of the edges and the center. As a result, a ringing current frequency can be further positively changed, and ringing amplitude can be reduced.

The skin effect and the proximity effect, which have been also described in the fifth example, are applied to the parallel asperity structure with respect to a current direction, which is used herein. An inductance can be changed although an effect of inductance change is lowered in comparison with the fifth example. Therefore, by incorporating the fifth example with the present example, an inductance can further have a variation range, and loss by a ringing current can be more effectively reduced.

### Seventh Example

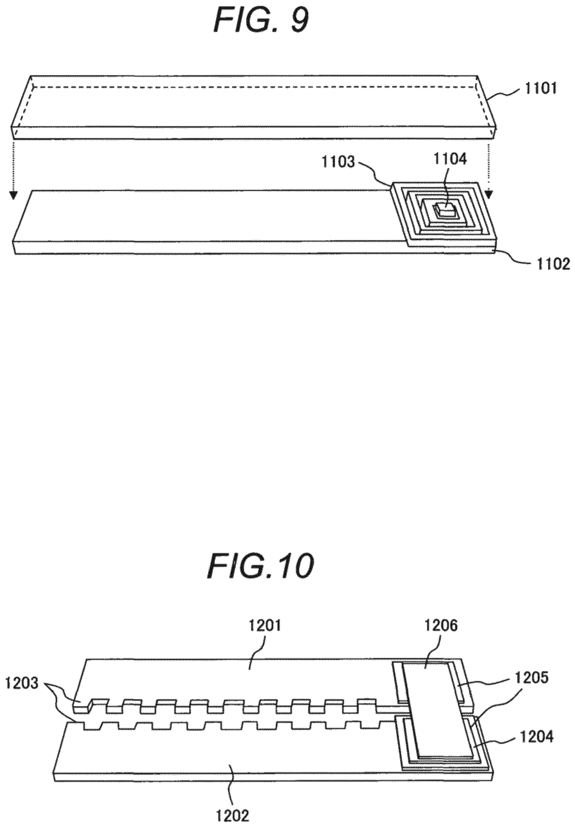

FIG. 9 indicates a structure similar to the asperity structure 903 illustrated in FIG. 7 described in the fifth example. In the structure, a circumference of a chip of a recovery diode 1104 is surrounded like a ripple by an asperity structure 1103. Therefore, an inductance can be controlled, and a frequency of a ringing current can be further positively changed. As a result, in comparison with the fifth example, loss by a ringing current can be further effectively reduced. Also in this case, a similar effect can be obtained if an upper electrode has a similar ripple structure.

### Eighth Example

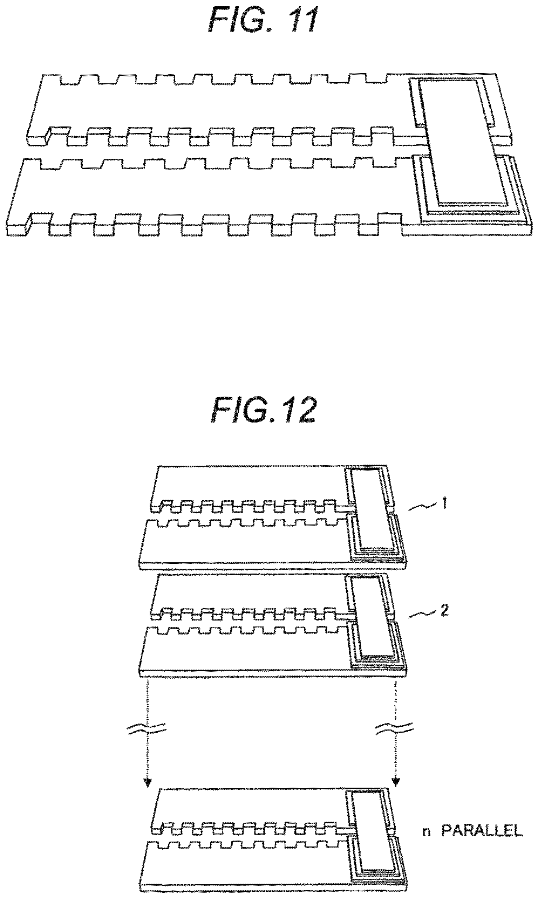

In FIG. 10, an inductance can be controlled by an effect similar to the asperity structure 903 illustrated in FIG. 7 described in the fifth example. A different point is that metal electrodes of a recovery diode 1204 are arranged on right and left sides, not upper and lower sides. Although a horizontal asperity structure 1203 is provided on an inner side of a loop including a deep-side metal electrode 1201 and a front-side metal electrode 1202, the effect can be obtained by providing the horizontal asperity structure on an outer side illustrated in FIG. 11. Furthermore, inductance change can be obtained by connecting the asperity structures in parallel as illustrated in FIG. 12. Therefore, in comparison with the fifth example, a ringing current frequency can be further positively changed, and loss by the ringing current can be further effectively reduced.

### Ninth Example

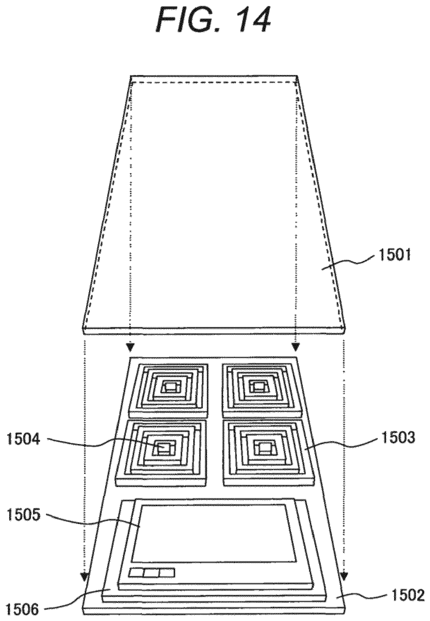

FIG. 14 illustrates a structure in which an inductance can be controlled by an effect of an asperity structure 1503 similar to the asperity structure 1103 illustrated in FIG. 9 described in the seventh example, and chips of the recovery diode 1104 according to the seventh example is connected in four parallels. Also, in FIG. 14, a number of asperities of the asperity structure 1503 is totally the same for convenience. However, in fact, the number is unlikely to be the same. Furthermore, although the asperity structure 1503 is provided only to a lower metal electrode 1502 in FIG. 14, the asperity structure 1503 may be provided only to an upper metal electrode 1501, or may be provided to both of the upper metal electrode 1501 and the lower metal electrode 1502.

FIG. 14 is a view mounting a switching device 1505, and close to the actual mounting image.

As described in the present example, inductance components can be further increased by providing an asperity structure by squarely surrounding a circumference of a diode. A ringing current frequency can be simply and further positively changed by changing a shape of the asperity structure. Therefore, loss by a ringing current can be further effectively reduced in comparison with the case of the fifth example.

### Tenth Example

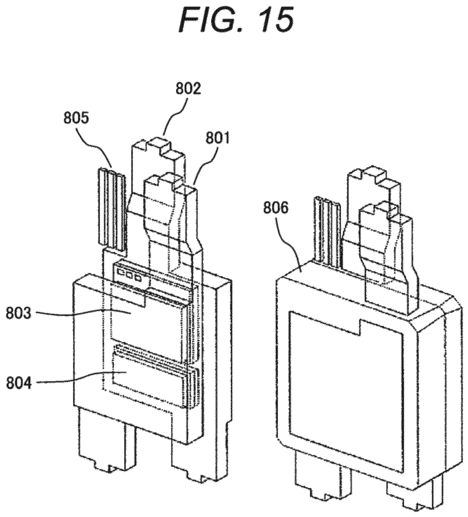

FIG. 15 is schematic views of a power converter (double side cooling type power module) mounting the fifth example of the present invention. A recovery diode is arranged at 804, and a switching device is arranged at 803. An upper metal electrode is arranged at 801, and a lower metal electrode is arranged at 802. The right view illustrates an outer shape molded by resin 806 to fix each component and sealed. In the left view, 804 indicates a lump of recovery diodes. Multiple recovery diodes are connected in parallel in the inside of 804.

The asperity structure described in the fifth example is provided to the upper electrode 801 and the lower electrode 802. Although, the semiconductor device according to the fourth example is mounted in the present example, other structure indicated in other examples may be mounted.

By applying the power conversion apparatus according to the present invention, noise can be reduced in addition to the effect of the fifth example, and a low-loss power converter can be provided.

### Reference Signs List

101a, 201a, 301a, 401a, 501a gate drive circuit 1
101b, 201b, 301b, 401b, 501b gate drive circuit 2
102a, 202a, 302a, 402a, 502a switching device on high-voltage side
102b, 202b, 302b, 402b, 502b switching device on low-voltage side
103L1, 203L1 to 203L4, 303L1 to 303L4, 503L1 series inductance in upper arm
103L2, 203L5 to 203L8, 303L5 to 303L8, 503L2 series inductance in lower arm
403La1 to 403Lan series inductance in upper arm (1 to n parallel numbers)
403Lb1 to 403Lbn series inductance in lower arm (1 to n parallel numbers)
104D1, 204D1 to 204D4, 304D1 to 304D4, 504D1 recovery diode
104D2, 204D5 to 204D8, 304D5 to 304D8, 504D2 recovery diode
404Da1 to 404Dan recovery diode (1 to n parallel numbers)
404Db1 to 404Dbn recovery diode (1 to n parallel numbers)
105, 205, 305, 405, 505 load
106, 206, 306, 406, 506 direct current power source
107, 207, 307, 407, 507 capacitor
508R1 series resistance in upper arm
508R2 series resistance in lower arm
801, 901, 1001, 1101, 1501, 1601 upper metal electrode
802, 902, 1002, 1102, 1502, 1602 lower metal electrode
1201 deep-side metal electrode
1202 front-side metal electrode
803, 1505, 1605 switching device
804, 904, 1004, 1104, 1204, 1504, 1604 recovery diode
805 gate drive terminal
806 resin mold
905, 1005, 1205, 1506, 1606 spacer
1206 connecting metal plate
903, 1003, 1103, 1203, 1503 asperity structure

## Claims

1. A semiconductor device, comprising:
a direct current power source (206);
a reference potential;
first and second arm circuits connected in series between the reference potential and the direct current power source (206); and
a load inductor (205) connected to a connection point between the first arm circuit and the second arm circuit,
wherein the first arm circuit includes:
a first switching device (202a); and
multiple first diodes (204D1-204D4) connected in parallel to the first switching device (202a), wherein only the multiple first diodes (204D1-204D4) are connected in parallel to the first switching device (202a) as recovery diodes for the first switching device (202a),
the second arm circuit includes:
a second switching device (202b); and
multiple second diodes (204D5-204D8) connected in parallel to a current path of the second switching device (202b), wherein only the multiple second diodes (204D5-204D8) are connected in parallel to the second switching device (202b) as recovery diodes for the second switching device (202b),
a forward direction of the first and second diodes is a direction from the reference potential to the direct current power source (206),
all of the first and second diodes are Si diodes or SiC diodes, and
the semiconductor device is arranged such that each length of the paths in which ringing currents, which flow by resonance between the junction capacitance of each diode and a series inductance in the switching upper arm when the switching devices (202a,202b) are turned on or off, flow between the multiple first diodes (204D1-204D4) and an output terminal of the direct current power source (206) is different for each of the first diodes.

2. The semiconductor device according to claim 1, wherein an electrode of a first diode has an asperity structure for the path of the ringing current.

3. The semiconductor device according to claim 2, wherein the asperity structure is provided on a line connecting the output terminal of the direct current power source (206) and an input terminal of the diode.

4. The semiconductor device according to claim 2, wherein an electrode of a second diode has an asperity structure.

5. The semiconductor device according to claim 1, wherein a relationship between f₁ and f₂ is represented by f₁ = n * f₂ (n ≠ an integer) in a case where a frequency of a current flowing to one of the first diodes is represented by f₁, and a frequency of a current flowing to another first diode is represented by f₂.

6. A power converter including the semiconductor device according to claim 1, comprising:
a first electrode; and
a second electrode,
wherein the first electrode and the second electrode are arranged so as to oppose each other,
the first and second switching devices and the first and second diodes are arranged between the first electrode and the second electrode, and
an asperity structure is provided to the first electrode or the second electrode.

## Patentansprüche

1. Halbleitervorrichtung, umfassend:
eine Gleichstromleistungsquelle (206);
ein Referenzpotenzial;
eine erste und eine zweite Zweigschaltung, die zwischen dem Referenzpotenzial und der Gleichstromleistungsquelle (206) in Serie geschaltet sind; und
einen Lastinduktor (205), der mit einem Verbindungspunkt zwischen der ersten Zweigschaltung und der zweiten Zweigschaltung verbunden ist,
wobei die erste Zweigschaltung Folgendes umfasst:
eine erste Schaltvorrichtung (202a); und
mehrere erste Dioden (204D1 - 204D4), die mit der ersten Schaltvorrichtung (202a) parallel geschaltet sind, wobei lediglich die mehreren ersten Dioden (204D1 - 204D4) mit der ersten Schaltvorrichtung (202a) als Freilaufdioden für die erste Schaltvorrichtung (202a) parallel geschaltet sind,
wobei die zweite Zweigschaltung Folgendes umfasst:
eine zweite Schaltvorrichtung (202b); und
mehrere zweite Dioden (204D5 - 204D8), die mit einem Strompfad der zweiten Schaltvorrichtung (202b) parallel geschaltet sind, wobei lediglich die mehreren zweiten Dioden (204D5 - 204D8) als Freilaufdioden für die zweite Schaltvorrichtung (202b) parallel zu der zweiten Schaltvorrichtung (202b) geschaltet sind,
wobei eine Durchlassrichtung der ersten und der zweiten Dioden eine Richtung vom Referenzpotenzial zur Gleichstromleistungsquelle (206) ist,
wobei alle der ersten und der zweiten Dioden Si-Dioden oder SiC-Dioden sind, und
wobei die Halbleitervorrichtung derart ausgelegt ist, dass jede Länge der Pfade, in denen Überschwingströme, die durch Resonanz zwischen der Sperrschichtkapazität von jeder Diode und einer Serieninduktivität in dem oberen Schaltzweig fließen, wenn die Schaltvorrichtungen (202a, 202b) ein- oder aus-geschaltet werden, zwischen den mehreren ersten Dioden (204D1 - 204D4) und einem Ausgangsanschluss der Gleichstromleistungsquelle (206) fließen, für jede der ersten Dioden unterschiedlich ist.

2. Halbleitervorrichtung gemäß Anspruch 1, wobei eine Elektrode einer ersten Diode eine Unebenheitsstruktur für den Pfad des Überschwingstroms aufweist.

3. Halbleitervorrichtung gemäß Anspruch 2, wobei die Unebenheitsstruktur auf einer Leitung bereitgestellt ist, die den Ausgangsanschluss der Gleichstromleistungsquelle (206) und einen Eingangsanschluss der Diode verbindet.

4. Halbleitervorrichtung gemäß Anspruch 2, wobei eine Elektrode einer zweiten Diode eine Unebenheitsstruktur aufweist.

5. Halbleitervorrichtung gemäß Anspruch 1, wobei eine Beziehung zwischen f₁ und f₂ durch f₁ = n * f₂ (n ≠ eine Ganzzahl) in einem Fall dargestellt wird, in dem eine Frequenz eines Stroms, der zu einer der ersten Dioden fließt, durch f₁ dargestellt wird, und eine Frequenz eines Stroms, der zu einer weiteren ersten Diode fließt, durch f₂ dargestellt wird.

6. Leistungswandler, umfassend die Halbleitervorrichtung gemäß Anspruch 1, umfassend:
eine erste Elektrode; und
eine zweite Elektrode,
wobei die erste Elektrode und die zweite Elektrode derart angeordnet sind, dass sie einander gegenüberliegen,
wobei die erste und die zweite Schaltvorrichtung, und die ersten und die zweiten Dioden zwischen der ersten Elektrode und der zweiten Elektrode angeordnet sind, und
wobei eine Unebenheitsstruktur an der ersten Elektrode oder der zweiten Elektrode bereitgestellt ist.

## Revendications

1. Dispositif à semi-conducteur, comprenant :
une source d'alimentation en courant continu (206) ;
un potentiel de référence ;
des premier et second circuits à bras connectés en série entre le potentiel de référence et la source d'alimentation en courant continu (206) ; et
un inducteur de charge (205) connecté à un point de connexion entre le premier circuit à bras et le second circuit à bras,
dans lequel le premier circuit à bras comprend :
un premier dispositif de commutation (202a) ; et
de multiples premières diodes (204D1-204D4) connectées en parallèle au premier dispositif de commutation (202a), dans lequel seules les multiples premières diodes (204D1-204D4) sont connectées en parallèle au premier dispositif de commutation (202a) en tant que diodes de récupération pour le premier dispositif de commutation (202a),
le second circuit à bras comprend :
un second dispositif de commutation (202b) ; et
de multiples secondes diodes (204D5-204D8) connectées en parallèle à un trajet de courant du second dispositif de commutation (202b), dans lequel seules les multiples secondes diodes (204D5-204D8) sont connectées en parallèle au second dispositif de commutation (202b) en tant que diodes de récupération pour le second dispositif de commutation (202b),
une direction vers l'avant des premières et secondes diodes est une direction allant du potentiel de référence à la source d'alimentation en courant continu (206),
toutes les première et seconde diodes sont des diodes Si ou des diodes SiC, et
le dispositif à semi-conducteur est agencé de sorte que chaque longueur des trajets dans lesquels circulent des courants d'appel, qui circulent par résonance entre la capacité de jonction de chaque diode et une inductance série dans le bras supérieur de commutation lorsque les dispositifs de commutation (202a, 202b) sont allumés ou éteints, et circulent entre les multiples premières diodes (204D1-204D4) et une borne de sortie de la source d'alimentation en courant continu (206), est différente pour chacune des premières diodes.

2. Dispositif à semi-conducteur selon la revendication 1, dans lequel une électrode d'une première diode a une structure d'aspérité pour le trajet du courant d'appel.

3. Dispositif à semiconducteur selon la revendication 2, dans lequel la structure d'aspérité est prévue sur une ligne reliant la borne de sortie de la source d'alimentation en courant continu (206) et une borne d'entrée de la diode.

4. Dispositif à semi-conducteur selon la revendication 2, dans lequel une électrode d'une seconde diode a une structure d'aspérité.

5. Dispositif à semi-conducteur selon la revendication 1, dans lequel une relation entre f₁ et f₂ est représentée par f₁=n*f₂ (n n'est pas un entier) dans un cas où une fréquence d'un courant circulant vers l'une des premières diodes est représentée par f₁, et la fréquence d'un courant circulant vers une autre première diode est représentée par f₂.

6. Convertisseur de puissance comprenant le dispositif à semi-conducteur selon la revendication 1, comprenant :
une première électrode ; et
une deuxième électrode,
dans lequel la première électrode et la seconde électrode sont agencées de manière à s'opposer,
les premier et second dispositifs de commutation et les première et seconde diodes sont agencés entre la première électrode et la seconde électrode, et
une structure d'aspérité est fournie à la première électrode ou à la seconde électrode.
